# EUROPEAN PATENT SPECIFICATION

(11) **EP 2 028 723 B1**
(45) Date of publication and mention of the grant of the patent: **17.08.2016**
(21) Application number: 07016293.8
(22) Date of filing: 20.08.2007
(51) Int. Cl.: H01R 12/59, H01R 12/77, H01R 12/79, H01R 13/719, H01R 43/00, H05K 1/02, H05K 1/03, H05K 1/14, H01F 17/00, H01F 17/06, H01F 27/255

(54) **Electrical device and manufacturing method thereof**
Elektrische Vorrichtung und Herstellungsverfahren dafür
Dispositif électrique et procédé de sa fabrication

(43) Date of publication of application: 25.02.2009
(73) Proprietor: Harman Becker Automotive Systems GmbH, 76307 Karlsbad (DE)
(72) Inventor: Kraft, Günther, 76133 Karlsruhe (DE); Defer, Alexey, 76287 Rheinstetten (DE); Lamparth, Oliver, 76359 Marxzell (DE); Richter, Martin, 76275 Ettlingen (DE)
(74) Representative: Grünecker Patent- und Rechtsanwälte PartG mbB

(56) References cited:
- DE-A1- 3 931 770
- DE-A1- 4 016 809
- JP-A- 5 101 859
- JP-A- 10 144 407
- US-A- 5 264 814

## Description

### Field of the invention

The present invention relates to an electrical device comprising a first electrical module, a second electrical module, a flexible conductor foil including a plurality of electrical conductors electrically connecting the first and second electrical module with each other, and a filtering element. The invention further describes a corresponding manufacturing method thereof. The invention relates in particular to an electrical device that is adapted to filter the electromagnetic interferences arising in the electrical conductors connecting the two electrical modules to each other.

### Background of the invention

The requirements with respect to Electromagnetic Compatibility, also referred to as EMC, on electrical devices are increasing. Different solutions have been proposed to provide for good EMC properties. In some solutions, the tracks arranged on the surface of a printed circuit board in the electrical device are individually electromagnetically filtered using filtering elements such as ferrite elements. In such solutions, each single track is individually filtered, thereby increasing the manufacturing costs of the electrical device.

In the previously described systems, the traces on the printing circuit boards are individually electromagnetically filtered. This solution however appears to be not suitable for performing electromagnetic filtering of the electrical conductors within a flexible conductor foil such as a Flexible Printed Circuit, also referred to as FPC, or in a Flexible Flat Cable, referred to as FFC. These flexible conductor foils electrically connect two electrical modules to each other and can have dimensions that are relatively large, thereby rendering individual electromagnetic filtering too expensive to implement. However, electromagnetic filtering of the conductors is required in the FFC or FPC elements, since they may carry interferences from an electromagnetically filtered printed circuit board to another electrical module, thereby potentially disturbing the functioning of the electrical device. There is therefore a need for providing a cost-effective electromagnetic filtering of the electrical conductors in a flexible conductor foil.

DE 3931770 A1 describes an absorbing device for absorbing electrical interferences, which are created within an electrical apparatus or which are introduced from the outside into the electrical apparatus over an electrical cable. The absorbing device for absorbing electrical interferences comprises two bodies made out of a magnetic material such as ferrite, which are adapted to enclose an electrical cable and absorb electrical interference, and a fixing device made out of elastic material, the fixing element comprising fasteners at both ends, which are connectable to each other or can be attached to a component of the electrical apparatus.

DE 4016809 A1 discloses an electric noise absorber comprising longitudinally divided pieces of magnetic substance (e.g. ferrite) shaped to surround the periphery of an electric cable when closed in a casing. Magnetic fluid is applied to at least one of the abutting planes of the ferrite pieces for securely contacting the abutting planes with each other.

US 5264814 shows an electronic noise absorber comprising a magnetic body for completely encompassing a portion of a flat cable connected to an electronic device and absorbing electrical noise flowing through that flat cable, and a fixing member for securing said magnetic body to the flat cable.

JP 5 101859 A discloses a relay connector for mutual connection of flat cables equipped with an anti-noise countermeasure. The relay connector includes a body, and two sliders installed supplementary at the two ends of the body. The sliders are intruded into the body and are equipped with ferrite. The ferrite has a hole with an inside shape that suits the outside shape of the flat cable to be inserted into the slider. When the slider is intruded into the body, the terminals of the flat cable are contacted with the terminals arranged inside of the body.

JP 10 144407 A describes a connector for a flat cable that includes a countermeasure against electromagnetic interference. A strain-in-leaf mounted in the connector is divided into two leaf elements. In these elements a split core formed by dividing a ferrite core into two parts is respectively stored. The leaf elements and the split cores are integrally connected, thereby the ferrite core is built in the strain-in-leaf.

### Summary of the invention

An object of the invention is therefore to provide an electrical device and a method for manufacturing the same that allow to achieve improved electromagnetic filtering of the electrical conductors within a flexible conductor foil, while guaranteeing reasonable manufacturing costs.

This object is solved by the subject matter of the independent claims. Preferred embodiments are subject matter of the dependent claims.

An example of an electrical device comprises a first electrical module, a second electrical module, a flexible conductor foil including a plurality of electrical conductors electrically connecting the first and second electrical module with each other, and a filtering element, wherein the filtering element is mechanically integrated in the electrical device and the flexible conductor foil is at least partially led through the filtering element, thereby electromagnetically filtering the plurality of electrical conductors.

According to a further example, the electrical device comprises a housing, wherein the filtering element is mechanically integrated in the housing.

According to a further example, the filtering element comprises a latching element and the housing comprises a corresponding recess, so that the filtering element latches with the housing upon insertion of the latching element into the corresponding recess.

According to a further example, the filtering element is made out of ferrite.

According to a further example, the first electrical module is a first printed circuit board and the second electrical module is one of a second printed circuit board or an electromechanical module.

An example of a method for manufacturing an electrical device comprises connecting a first electrical module to a second electrical module by a flexible conductor foil, said flexible conductor foil including a plurality of electrical conductors electrically connecting the first and second electrical module with each other, and mechanically integrating a filtering element in the electrical device, wherein the flexible conductor foil is at least partially led through the filtering element, thereby electromagnetically filtering the plurality of electrical conductors.

### Brief description of the Figures

**Fig. 1** is an overview of a printed circuit board with a filtering element arranged thereon;
**Fig. 2** is a side view of the printed circuit board shown in Fig. 1;
**Fig. 3** is an overview of a portion of a housing with a filtering element arranged thereon according to an embodiment of the invention;
**Fig. 4** is a side view of the portion of a housing shown in Fig. 3;
**Fig. 5** is another side view of the portion of a housing shown in Fig. 3.

### Detailed description

Reference will now be made in detail to the embodiments of the invention, examples of which are illustrated in the accompanying drawings, wherein like reference numerals refer to the like reference elements throughout. The embodiments are described below by way of example in order to explain the invention by referring to the figures but are not limited thereto.

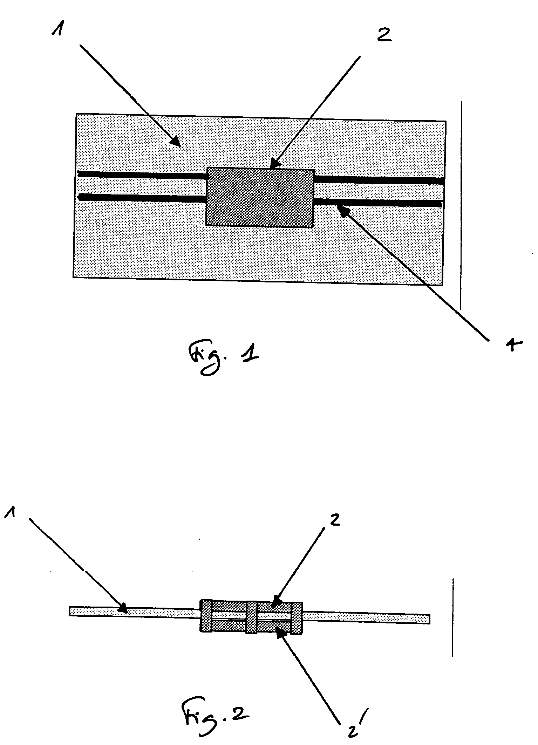

Fig. 1 describes a system, which comprises a printed circuit board 1 having a plurality of electrical conductors 4 arranged thereon, wherein the electrical conductors 4 are electromagnetically filtered by a filtering element 2. The filtering element 2 is provided to filter the plurality of electrical conductors 4. Even though Fig. 1 represents the particular case of two electrical conductors being filtered by the filtering element 2, it may be considered to filter an arbitrary number of electrical conductors. Fig. 1 shows an overview of the system, wherein the top surface of the filtering element 2 is represented.

Fig. 2 shows a side view of the system represented in Fig. 1, wherein the structure of the filtering element 2 is represented. The filtering element comprises a first filtering element 2 and a second filtering element 2' that are connectable to each other to form a filtering chamber. The first filtering element 2 is adapted to be inserted into through-holes of the printed circuit board 1, on a first side of the printed circuit board 1. In the example shown in Fig. 1, the first filtering element 2 is arranged on the first side of the printed circuit board 1, on which the electrical traces 4 are foreseen. Hence, the electrical conductors 4 are enclosed between the surface of the printed circuit board 1 and the first filtering element 2.

As can be seen in Fig. 2, the second filtering element 2' is arranged on the second side of the printed circuit board 1. The second filtering element 2' is adapted to be inserted into through-holes of the printed circuit board 1, in such a way that the first filtering element 2 and the second filtering element 2' form a filtering chamber, thereby electromagnetically filtering the electrical conductors 4 arranged on the surface of the printed circuit board 1.

The filtering element 2 is made out of a material that is adapted to filter the electromagnetic interferences emitted by the electrical conductors on the surface of the printed circuit board 1, such as, for example, ferrite. Alternatively, the filtering element may be formed of iron powder. For mechanical issues, a bonding agent made of iron powder or ferrite may be used.

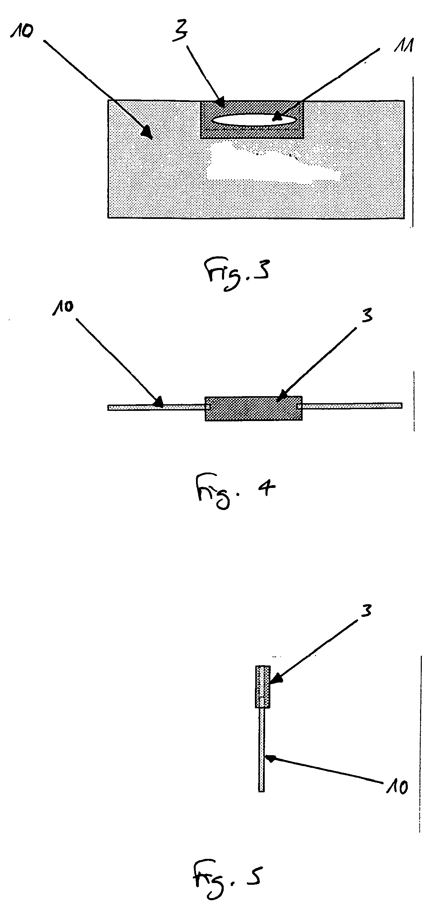

An electrical device according to an embodiment of the invention will now be described with respect to Figs. 3 to 5. An electrical device comprises a first electrical module and a second electrical module (not shown).The electrical device further comprises a housing, in which the first and second electrical module are embedded, separated in two portions of the housing. Fig. 3 shows a portion 10 of the housing. In the embodiment represented in Fig. 3, the filtering element 3 is integrated in the portion 10 of the housing.

The filtering element 3 shown in Fig. 3 may comprise an opening 11, through which a flexible conductor foil (not shown) including a plurality of electrical conductors electrically connecting the first and second electrical module with each other can be at least partially led, thereby electromagnetically filtering the plurality of electrical conductors.

The flexible conductor foil may be e.g. a Flexible Printed Circuit FPC or a Flexible Flat Cable FFC. The flexible conductor foil has a plurality of electrical conductors arranged therein. Fig. 3 shows that the flexible conductor foil can be led through the filtering element 3, which is integrated in the portion 10 of the housing of the electrical device and enables to electromagnetically filter the plurality of electrical conductors arranged in the flexible conductor foil'. Since the filtering element 3 is mechanically integrated into the electrical device, this allows to electromagnetically filter the plurality of electrical conductors of the flexible conductor foil without having to filter them individually. This enables a reduction of the manufacturing costs related to the electromagnetic filtering of the electrical conductors, while guaranteeing a high level of electromagnetic filtering.

The filtering element 3 is preferentially a block made out of ferrite, wherein its form determines the filtering properties. Indeed, the form of the ferrite block and the mechanical integration into the electrical device determine the filtering properties of the LC filter formed by the ferrite block. A person skilled in the art would consider the appropriate form of the ferrite block that corresponds to the particular application that is targeted. Alternatively, the filtering element may also be formed of iron powder. For mechanical issues, a bonding agent made of iron powder or ferrite may be used.

Fig. 4 shows a side view of the portion 10 of the housing of the electrical device with the mechanically integrated filtering element 3 according to an embodiment of the invention represented in Fig. 3. Fig. 5 shows another side view of the portion 10 of the housing of the electrical device with the filtering element 3.

According to an embodiment of the invention, the electrical device comprises a housing, wherein the filtering element is mechanically integrated in the housing of the electrical device. According to yet another embodiment, the filtering element comprises a latching element and the housing comprises a corresponding recess, so that the filtering element latches with the housing upon insertion of the latching element in the corresponding recess. This allows to mechanically integrate the filtering element in the electrical device in a reliable manner.

The first electrical module is preferentially a first printed circuit board, and the flexible conductor foil may connect the first printed circuit board to either a second printed circuit board or to an electromechanical module, such as a drive, or an electrical module such as a DAB or Sirius module, for example.

## Claims

1. An electrical device comprising:
a first electrical module,
a second electrical module,
a housing, in which the first electrical module and the second electrical module are embedded, a flexible conductor foil including a plurality of electrical conductors electrically connecting the first and second electrical module with each other, and
a filtering element (3) including an opening (11),
wherein the filtering element (3) is mechanically integrated in a portion (10) of the housing and the flexible conductor foil is at least partially led through the opening (11) of the filtering element (3), thereby electromagnetically filtering the plurality of electrical conductors,
**characterized in that**
the opening (11) is extending through the filtering element perpendicular to the plane surface of the portion (10) of the housing, and
the first module and the second module are embedded in two regions of the housing that are separated by the portion (10) of the housing.

2. The electrical device according to claim 1, wherein the filtering element (3) comprises a latching element and the housing comprises a corresponding recess, so that the filtering element (3) latches with the housing upon insertion of the latching element into the corresponding recess.

3. The electrical device according to claim 1 or 2, wherein the filtering element (3) is made out of ferrite.

4. The electrical device according to one of claims 1 to 3, wherein the first electrical module is a first printed circuit board and the second electrical module is one of a second printed circuit board or an electromechanical module.

5. A method for manufacturing an electrical device having a housing, in which a first electrical module and a second electrical module are embedded, said method comprising the following steps:
connecting a first electrical module to a second electrical module by a flexible conductor foil, said flexible conductor foil including a plurality of electrical conductors electrically connecting the first and second electrical module with each other, and
mechanically integrating a filtering element (3) in a portion (10) of the housing,
wherein the flexible conductor foil is at least partially led through an opening (11) of the filtering element (3), thereby electromagnetically filtering the plurality of electrical conductors,
**characterized in that**
the opening (11) is extending through the filtering element (3) perpendicular to the plane surface of the portion (10) of the housing, and
the first module and the second module are embedded in two regions of the housing that are separated by the portion (10) of the housing.

## Patentansprüche

1. Elektrische Vorrichtung, umfassend:
ein erstes elektrisches Modul,
ein zweites elektrisches Modul,
ein Gehäuse, in dem das erste elektrische Modul und das zweite elektrische Modul eingebettet sind, wobei eine flexible Leiterfolie, die eine Vielzahl von elektrischen Leitern beinhaltet, das erste und zweite Modul miteinander verbindet, und
ein Filterelement (3), das eine Öffnung (11) beinhaltet,
wobei das Filterelement (3) mechanisch in einen Teil (10) des Gehäuses integriert ist und die flexible Leiterfolie zumindest teilweise durch die Öffnung (11) des Filterelements (3) geführt wird, so dass die Vielzahl der elektrischen Leiter dadurch elektromagnetisch gefiltert wird,
**dadurch gekennzeichnet, dass**
sich die Öffnung (11) durch das Filterelement senkrecht zur ebenen Oberfläche des Teils (10) des Gehäuses erstreckt, und
das erste Modul und das zweite Modul in zwei Regionen des Gehäuses eingebettet sind, die durch den Teil (10) des Gehäuses getrennt werden.

2. Elektrische Vorrichtung nach Anspruch 1, wobei das Filterelement (3) ein Rastelement umfasst und das Gehäuse eine entsprechende Vertiefung umfasst, so dass das Filterelement (3) beim Einführen des Rastelements in die entsprechende Vertiefung im Gehäuse einrastet.

3. Elektrische Vorrichtung nach Anspruch 1 oder 2, wobei das Filterelement (3) aus Ferrit hergestellt ist.

4. Elektrische Vorrichtung nach einem der Ansprüche 1 bis 3, wobei das erste elektrische Modul eine erste Leiterplatte ist und das zweite elektrische Modul eines von einer zweiten Leiterplatte oder einem elektromechanischen Modul ist.

5. Verfahren zum Herstellen einer elektrischen Vorrichtung mit einem Gehäuse, in dem ein erstes elektrisches Modul und ein zweites elektrisches Modul eingebettet sind, wobei das Verfahren die folgenden Schritte umfasst:
Verbinden eines ersten elektrischen Moduls mit einem zweiten elektrischen Modul durch eine flexible Leiterfolie, wobei die flexible Leiterfolie eine Vielzahl von elektrischen Leitern beinhaltet, die das erste und zweite elektrische Modul elektrisch miteinander verbinden, und
mechanisches Integrieren eines Filterelements (3) in einem Teil (10) des Gehäuses,
wobei die flexible Leiterfolie zumindest teilweise durch eine Öffnung (11) des Filterelements (3) geführt wird, so dass die Vielzahl von elektrischen Leitern dadurch elektromagnetisch gefiltert wird,
**dadurch gekennzeichnet, dass**
sich die Öffnung (11) durch das Filterelement (3) senkrecht zur ebenen Oberfläche des Teils (10) des Gehäuses erstreckt, und
das erste Modul und das zweite Modul in zwei Regionen des Gehäuses eingebettet sind, die durch den Teil (10) des Gehäuses getrennt werden.

## Revendications

1. Dispositif électrique comprenant :
un premier module électrique,
un deuxième module électrique,
un boîtier, dans lequel le premier module électrique et le deuxième module électrique sont incorporés,
un film conducteur flexible comportant une pluralité de conducteurs électriques connectant électriquement les premier et deuxième modules électriques l'un à l'autre, et
un élément filtrant (3) comportant une ouverture (11),
dans lequel l'élément filtrant (3) est intégré mécaniquement dans une partie (10) du boîtier et le film conducteur flexible est amené au moins partiellement à travers l'ouverture (11) de l'élément filtrant (3), filtrant ainsi électromagnétiquement la pluralité de conducteurs électriques,
**caractérisé en ce que**
l'ouverture (11) s'étend à travers l'élément filtrant perpendiculairement à la surface plane de la partie (10) du boîtier, et
le premier module et le deuxième module sont incorporés dans deux régions du boîtier qui sont séparées par la partie (10) du boîtier.

2. Dispositif électrique selon la revendication 1, dans lequel l'élément filtrant (3) comprend un élément de verrouillage et le boîtier comprend une fente correspondante, de telle sorte que l'élément filtrant (3) se verrouille au boîtier lors de l'insertion de l'élément de verrouillage dans la fente correspondante.

3. Dispositif électrique selon la revendication 1 ou 2, dans lequel l'élément filtrant (3) est réalisé en ferrite.

4. Dispositif électrique selon l'une des revendications 1 à 3, dans lequel le premier module électrique est une première carte de circuit imprimé et le deuxième module électrique est un élément parmi une deuxième carte de circuit imprimé ou un module électromécanique.

5. Procédé de fabrication d'un dispositif électrique ayant un boîtier, dans lequel un premier module électrique et un deuxième module électrique sont incorporés, ledit procédé comprenant les étapes suivantes :
connexion d'un premier module électrique à un deuxième module électrique par un film conducteur flexible, ledit film conducteur flexible comportant une pluralité de conducteurs électriques connectant électriquement les premier et deuxième modules électriques l'un à l'autre, et
intégration mécanique d'un élément filtrant (3) dans une partie (10) du boîtier,
dans lequel le film conducteur flexible traverse est amené au moins partiellement à travers une ouverture (11) de l'élément filtrant (3), filtrant ainsi électromagnétiquement la pluralité de conducteurs électriques,
**caractérisé en ce que**
l'ouverture (11) s'étend à travers l'élément filtrant (3) perpendiculairement à la surface plane de la partie (10) du boîtier, et
le premier module et le deuxième module sont incorporés dans deux régions du boîtier qui sont séparées par la partie (10) du boîtier.
